# EUROPEAN PATENT APPLICATION

(11) **EP 2 953 229 A1**
(43) Date of publication of application: **09.12.2015**
(21) Application number: 15169346.2
(22) Date of filing: 27.05.2015
(51) Int. Cl.: H02J 3/42, H02H 11/00

(54) **METHOD OF REDUNDANT MONITORING AND PROTECTION OF AC POWER GENERATION CHANNELS**

(30) Priority: 03.06.2014 US 201414294313
(71) Applicant: Hamilton Sundstrand Corporation, Charlotte, NC 28217 (US)
(72) Inventor: IVES, Kyle Stephen, Whitefish Bay, WI 53217 (US); GOOD, Jef William, German Valley, IL Illinois 61039 (US)
(74) Representative: Hughes, Andrea Michelle

(57) **Abstract**

A power quality control circuit is connected to monitor an AC input power and selectively connect the AC input power through a contactor 12. The power quality control circuit 30 includes power quality monitor circuitry 32 that determines whether the AC input power has an overfrequency condition, an underfrequency condition, an overvoltage condition or an undervoltage condition, and prevents closing of the contactor in response to a determination of any of those conditions.

## Description

### BACKGROUND

The present disclosure relates to a system and method for performing power quality monitoring that is physically separate from software monitoring of a generator control unit (GCU).

The certification environments for aircraft have begun to put an increasing emphasis on AC power quality in their electrical systems. As a result, separate and dissimilar devices are required to monitor the AC power quality from the generator controller. Aircraft power systems have therefore been designed to include additional protection against power quality faults.

### SUMMARY

A power quality control circuit may be connected to monitor AC input power and selectively connect the AC input power through a contactor. The power quality control circuit includes overfrequency detection circuitry operable to determine whether a frequency of the AC input power exceeds an upper limit threshold frequency for a first time that signifies an overfrequency condition, underfrequency detection circuitry operable to determine whether the frequency of the AC input power is less than a lower limit threshold frequency for a second time that signifies an underfrequency condition, overvoltage detection circuitry operable to determine whether a voltage of the AC input power exceeds an upper limit threshold voltage for a third time that signifies an overvoltage condition, and undervoltage detection circuitry operable to determine whether the voltage of the AC input power is less than a lower limit threshold voltage for a fourth time that signifies an undervoltage condition. A relay is connected to the power quality monitor circuitry for connection to the contactor coil. The relay is controllable to prevent closing of the contactor in response to a determination by the power quality monitor circuitry of the overfrequency condition, the underfrequency condition, the overvoltage condition or the undervoltage condition.

### BRIEF DESCRIPTION OF THE DRAWINGS

FIG. 1 is a simplified schematic diagram of an AC power generation circuit having power quality monitoring and protection according to an embodiment of the present invention.
FIG. 2 is a block diagram of an embodiment of a power quality monitoring circuit.

### DETAILED DESCRIPTION

A power quality control circuit according to embodiments of the present invention is connected to monitor AC input power and selectively connect the AC input power to aircraft loads through a contactor. The power quality control circuit includes power quality monitor circuitry that determines whether the AC input power has an overfrequency condition, an underfrequency condition, an overvoltage condition or an undervoltage condition, and prevents closing of the contactor in response to a determination of any of those conditions, such as by controlling a relay connected to the contactor.

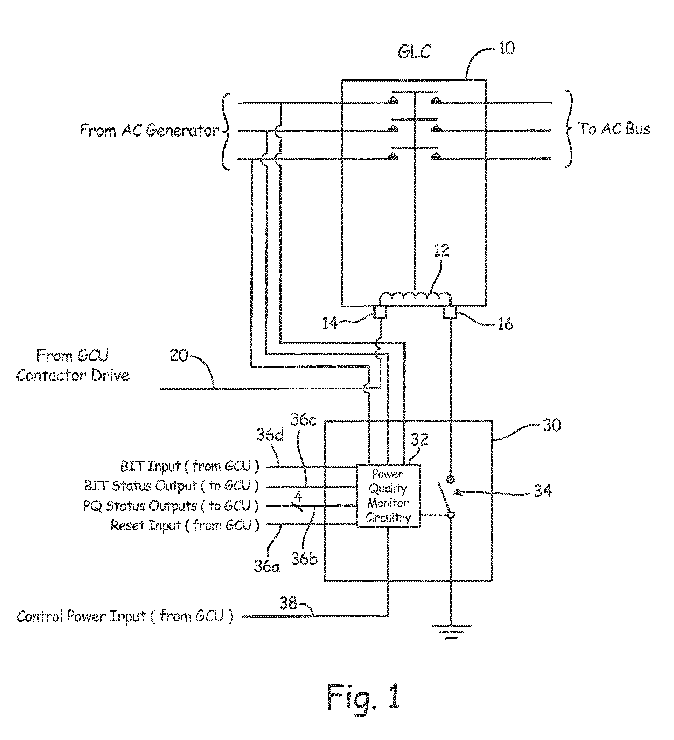

FIG. 1 is a simplified schematic diagram of an AC power generation circuit having power quality monitoring and protection according to an embodiment of the present invention. The AC power generation circuit includes generator line contactor (GLC) circuit 10 that selectively connects three-phase AC input power from an aircraft AC generator to an AC bus for powering various aircraft loads. This connection is activated by closing contactor coil 12, which is connected between terminals 14 and 16. The closing of contactor coil 12 is generally controlled by contactor drive control signal 20 from a generator control unit (GCU), such as by a 28 Volt DC signal. The GCU provides some protection against power quality issues by itself monitoring the power input signal, as is generally known in the art, and only closes contactor coil 12 when a control signal from the GCU indicates that conditions allow operation and coupling of the AC input power to the AC bus. However, in order to provide additional protection, the circuit shown in FIG. 1 further includes power quality control circuit 30 to separately and independently monitor the quality of the AC input power. Power quality control circuit 30 is located in a physically separate circuit location from the GCU.

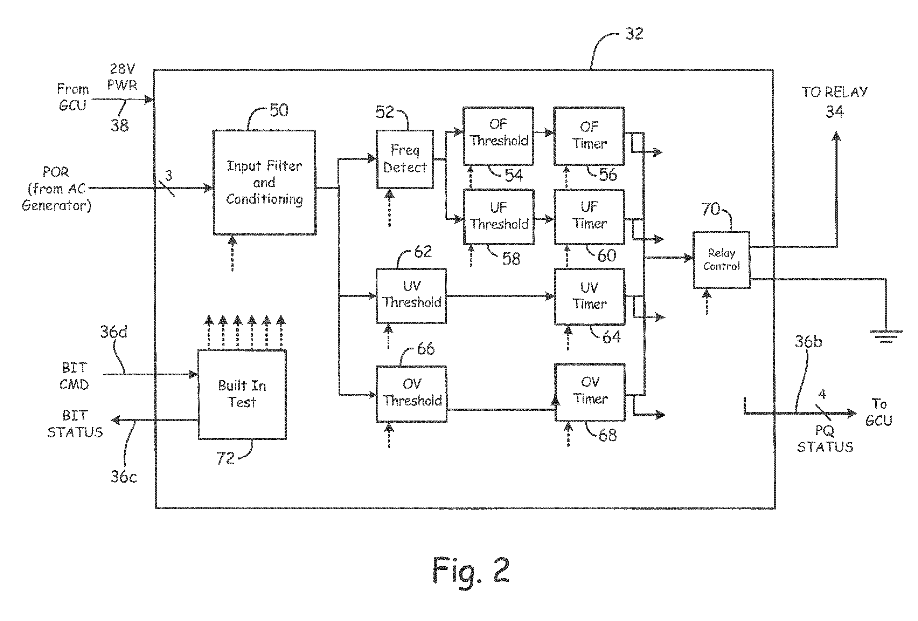

Power quality control circuit 30 includes power quality monitor circuitry 32 that is connected to receive a representation (e.g., stepped down) of the three-phase power input signal, and includes relay 34 connected between contactor terminal 16 and ground, controlled by an output of power quality monitor circuitry 32. Power quality monitor circuitry 32 is operable to monitor the three-phase power input signal, and only close relay 34 (to allow contactor coil 12 to be closed by contactor drive control signal 20 from the GCU) if the power quality of the three-phase power input signal is within specifications, including voltage and frequency specifications. Specifically, power quality monitor circuitry 32 detects overvoltage, undervoltage, overfrequency and underfrequency conditions in the power input signal, and only operates to close relay 34 when none of those conditions are detected. Power quality monitor circuitry 32 also outputs power quality status signals 36b to the GCU, for processing and indicating status to aircraft avionics, and for selected action by the GCU, depending on the type of power quality issue(s) that are indicated by the power quality status signals. Relay 34 is a normally-open relay, so that if power quality monitor circuitry 32 loses power or otherwise fails to operate, relay 34 remains open so that contactor coil 12 is not able to be closed to couple the three-phase power input signal to the AC bus. Power quality monitor circuitry 32 also receives a reset input 36a from the GCU. The details of power quality monitor circuitry 32 will be discussed in detail below with reference to FIG. 2.

In an exemplary embodiment, power quality monitor circuitry 32 is powered by control power input 38 from the GCU. Power quality monitor circuitry 32 can be powered by the GCU because it is only necessary for power quality monitor circuitry 32 when the GCU is operating and providing power. When the GCU is not operating and providing power, such as due to a loss of power, then power quality monitor circuitry 32 will not operate, and normally-open relay 34 will remain open, preventing contactor coil 12 from being closed.

Power quality monitor circuitry 32 includes a built-in test (BIT) signal input 36d from the GCU, and a BIT status signal output 36c to the GCU. This allows the GCU to periodically inject a test signal into the functional portions of power quality monitor circuitry 32, to test the operation of the power quality monitor circuitry and ensure that it will properly detect power quality issues and conditions.

FIG. 2 is a block diagram of an embodiment of power quality monitoring circuitry 32, showing the functions of the circuitry in more detail. Power quality monitor circuitry 32 provides the ability to determine overvoltage, undervoltage, overfrequency and underfrequency conditions of the AC input power. Power quality monitor circuitry 32 includes input filter and conditioning circuitry 50, frequency detection circuitry 52, overfrequency threshold circuit 54, overfrequency timer 56, underfrequency threshold circuit 58, underfrequency timer 60, undervoltage threshold circuit 62, undervoltage timer 64, overvoltage threshold circuit 66, overvoltage timer 68, power quality monitor relay control circuit 70, and built-in test circuit 72.

Power quality monitor circuitry 32 receives control power input 38 from the GCU, which is shown in FIG. 2 as a 28 Volt DC power signal. Power quality monitor circuitry 32 also receives the three-phase AC input power from the point of regulation (POR) of that power, that is, the AC input power from the aircraft AC generator is regulated at the POR so as to be in condition for connection to the AC bus. This three-phase AC input power is filtered and stepped down by input filter and conditioning circuitry 50, to create a lower voltage representation of the AC input power. In one embodiment, the representation of the AC input power may be stepped down from 115 Vrms to 10 Vrms. The representation of the AC input power is then received by frequency detection circuitry 52, undervoltage threshold circuit 62 and overvoltage threshold circuit 66.

Frequency detection circuitry 52 receives the stepped down input signal and detects the frequency of the signal. This may be accomplished in a number of ways. For example, a zero crossing circuit, a counter and a timer may be used to determine the number of cycles of the signal for a known period of time. Other frequency detection configurations may alternatively be used. The determined frequency of the stepped down input signal is output from frequency detection circuitry 52 to overfrequency threshold circuit 54 and underfrequency threshold circuit 58. In overfrequency threshold circuit 54, the determined frequency is compared to an upper limit frequency threshold. In an exemplary embodiment, the upper limit frequency threshold is set to 423 Hz (+/- 2 Hz). If the frequency exceeds the upper limit frequency threshold, a "true" signal (such as a logical one or zero) is output to overfrequency timer 56. If the "true" signal is maintained for a time that exceeds a threshold time (set in overfrequency timer 56, for example 6.0 seconds +/- 0.5 seconds in an exemplary embodiment), then overfrequency timer 56 outputs an overfrequency "true" signal to relay control circuit 70 to indicate an overfrequency condition. The overfrequency "true" signal is also output to the GCU on power quality status line 36b, so that the GCU can de-energize the AC power generator.

In underfrequency threshold circuit 58, the determined frequency is compared to a lower limit frequency threshold. If the frequency is less than the lower limit frequency threshold, a "true" signal (such as a logical one or zero) is output to underfrequency timer 60. In an exemplary embodiment, the lower limit frequency threshold is set to 377 Hz (+/- 2 Hz). If the "true" signal is maintained for a time that exceeds a threshold time (set in underfrequency timer 60, for example 6.0 seconds +/- 0.5 seconds in an exemplary embodiment), then underfrequency timer 60 outputs an underfrequency "true" signal to relay control circuit 70 to indicate an underfrequency condition. The underfrequency "true" signal is also output to the GCU on PQ STATUS line 36b, so that the GCU can de-energize the AC power generator.

Undervoltage threshold circuit 62 receives the stepped down input signal and compares it to a lower limit threshold voltage. If the voltage is less than the lower limit threshold voltage, a "true" signal (such as a logical one or zero) is output to undervoltage timer 64. In an exemplary embodiment, the lower limit threshold voltage is set to 102.5 Volts (+/- 2 Volts rms). In most embodiments, this comparison is done for each phase of the input signal. If the "true" signal is maintained for a time that exceeds a threshold time (set in undervoltage timer 64, for example 6.0 seconds +/- 0.5 seconds in an exemplary embodiment), then undervoltage timer 64 outputs an undervoltage "true" signal to relay control circuit 70 to indicate an undervoltage condition. The undervoltage "true" signal is also output to the GCU on PQ STATUS line 36b, so that the GCU can de-energize the AC power generator.

Overvoltage threshold circuit 66 receives the stepped down input signal and compares it to an upper limit threshold voltage. If the voltage exceeds the upper limit threshold voltage, a "true" signal (such as a logical one or zero) is output to overvoltage timer 68. In an exemplary embodiment, the upper limit threshold voltage is set to 131.5 Volts (+/- 2.5 Volts rms). In most embodiments, this comparison is done for each phase of the input signal. If the "true" signal is maintained for a time that exceeds a threshold time (set in overvoltage timer 68, for example 250 milliseconds +/- 25 milliseconds in an exemplary embodiment), then overvoltage timer 68 outputs an overvoltage "true" signal to relay control circuit 70 to indicate an overvoltage condition. The overvoltage "true" signal is also output to the GCU on PQ STATUS line 36b, so that the GCU can de-energize the AC power generator. In some embodiments, the overvoltage branch of the monitoring and protection circuitry is designed to ensure removal of AC voltage from the AC bus (FIG. 1) within a time of less than 300 milliseconds, in part by setting the threshold time in overvoltage timer 68 accordingly.

Relay control circuit receives indications of overfrequency, underfrequency, undervoltage and/or overvoltage conditions, and in an exemplary embodiment, will only output a signal to close relay 34 (FIG. 1) and thereby allow closing of contactor coil 12 in GLC 10 (FIG. 1) if none of these conditions are present. In this way, protection is provided against providing power through GLC 10 when undesirable power quality conditions are present.

A built-in test command signal 36d (shown as BIT CMD) is provided from the GCU as an input to built-in test circuit 72. This allows the GCU to periodically command power quality monitor circuitry 32 to perform a test of its operations, to confirm that the overfrequency, underfrequency, overvoltage and undervoltage circuits are all working properly. A series of test signals may be injected into input filter and conditioning circuitry 50 that are set to produce predetermined results if the components of power quality monitor circuitry 32 are working properly, and the built-in test circuit 72 can output a status signal 36c (shown as BIT STATUS) to the GCU to indicate, based on the results of the test, whether power quality monitor circuitry is working properly.

As was mentioned above, power quality monitor circuitry 32 is an independent and dissimilar mechanism for monitoring overvoltage, undervoltage, overfrequency and underfrequency conditions of the AC input power at a selected point of regulation (POR). Power quality monitor circuitry is also physically located in a separate installation position from the GCU. This separate and redundant monitoring of power quality (along with the microcontroller-based monitoring performed by the GCU) can provide protection that satisfies high importance level classifications of these conditions, such as a "catastrophic" classification which typically requires an extremely low probability of such conditions.

### Discussion of Possible Embodiments

The following are non-exclusive descriptions of possible embodiments of the present invention.

A power quality control circuit according to an exemplary embodiment of this disclosure may be configured to monitor an AC input power and selectively connect the AC input power through a contactor, and may include among other possible things a power quality monitor circuitry connected to receive the AC input power, the power quality monitor circuitry comprising overfrequency detection circuitry operable to determine whether a frequency of the AC input power exceeds an upper limit threshold frequency for a first time that signifies an overfrequency condition, underfrequency detection circuitry operable to determine whether the frequency of the AC input power is less than a lower limit threshold frequency for a second time that signifies an underfrequency condition, overvoltage detection circuitry operable to determine whether a voltage of the AC input power exceeds an upper limit threshold voltage for a third time that signifies an overvoltage condition, and undervoltage detection circuitry operable to determine whether the voltage of the AC input power is less than a lower limit threshold voltage for a fourth time that signifies an undervoltage condition, and the power quality control circuit may also comprise a relay connected to the power quality monitor circuitry for connection to the contactor coil, the relay being controlled to prevent closing of the contactor in response to a determination by the power quality monitor circuitry of the overfrequency condition, the underfrequency condition, the overvoltage condition or the undervoltage condition.

The power quality control circuit of the preceding paragraph can optionally include, additionally and/or alternatively, any one or more of the following features, configurations and/or additional components:

The contactor through which AC input power is selectively connected by the power quality control circuit may be configured to connect the AC input power to an aircraft AC bus when the contactor is closed.

The relay of the power quality control circuit may be a normally-open relay that is closed to enable closing of the contactor only in the absence of a determination by the power quality monitor circuitry of the overfrequency condition, the underfrequency condition, the overvoltage condition or the undervoltage condition.

The contactor through which AC input power is selectively connected by the power quality control circuit may be configured to receive a control signal from a generator control unit (GCU) to control opening and closing of the contactor, and the relay may be controlled to prevent closing of the contactor, regardless of whether the control signal from the GCU instructs the contactor to open, in response to the determination by the power quality monitor circuitry of the overfrequency condition, the underfrequency condition, the overvoltage condition or the undervoltage condition.

The power quality monitor circuitry may be configured to receive operating power from the GCU.

The power quality monitor circuitry may be configured to output an overfrequency status signal, an underfrequency status signal, an overvoltage status signal and an undervoltage status signal for communication to the GCU.

The power quality monitor circuitry may include a built-in test circuit controllable by the GCU to inject test signals to evaluate and ensure proper operation of the overfrequency detection circuitry, the underfrequency detection circuitry, the overvoltage detection circuitry and/or the undervoltage detection circuitry.

The power quality monitor circuitry may be physically located in a separate location from the GCU.

The third time may be between 225 and 275 milliseconds.

The power quality monitor circuitry may include conditioning circuitry that steps down the voltage of the AC input power for evaluation in the power quality monitor circuitry.

A method of monitoring power quality of an AC input power and selectively enabling connection of the AC input power through a contact according to an exemplary embodiment of this disclosure may comprise determining whether a frequency of the AC input power exceeds an upper limit threshold frequency for a first time that signifies an overfrequency condition, determining whether the frequency of the AC input power is less than a lower limit threshold frequency for a second time that signifies an underfrequency condition, determining whether a voltage of the AC input power exceeds an upper limit threshold voltage for a third time that signifies an overvoltage condition, determining whether the voltage of the AC input power is less than a lower limit threshold voltage for a fourth time that signifies an undervoltage condition, and selectively preventing closing of the contactor in response to determination of the overfrequency condition, the underfrequency condition, the overvoltage condition or the undervoltage condition.

The method of the preceding paragraph can optionally include, additionally and/or alternatively, any one or more of the following features, configurations, steps and/or additional components:

The contactor may receive a control signal from a generator control unit (GCU) to control opening and closing of the contactor, and the contactor may be selectively prevented from closing, regardless of whether the control signal from the GCU instructs the contactor to open, in response to the determination of the overfrequency condition, the underfrequency condition, the overvoltage condition or the undervoltage condition.

The method may further include generating an overfrequency status signal, an underfrequency status signal, an overvoltage status signal and an undervoltage status signal based on a result of the determination of the overfrequency condition, the underfrequency condition, the overvoltage condition and the undervoltage condition, and communicating the overfrequency status signal, the underfrequency status signal, the overvoltage status signal and the undervoltage status signal to the GCU.

The third time may be between 225 and 275 milliseconds.

The method may further include stepping down the voltage of the AC input power prior to the steps of determining the overfrequency condition, the underfrequency condition, the overvoltage condition and the undervoltage condition.

While the invention has been described with reference to an exemplary embodiment(s), it will be understood by those skilled in the art that the invention not be limited to the particular embodiment(s) disclosed, but that the invention will include all embodiments falling within the scope of the appended claims.

## Claims

1. A power quality monitor and control circuit configured to monitor an AC input power and selectively connect the AC input power through a contactor coil, the power quality control circuit (30) comprising:
power quality monitor circuitry (32) connected to receive the AC input power, the power quality monitor circuitry comprising:
overfrequency detection circuitry (52, 54, 56) operable to determine whether a frequency of the AC input power exceeds an upper limit threshold frequency for a first time that signifies an overfrequency condition;
underfrequency detection circuitry (52, 58, 60) operable to determine whether the frequency of the AC input power is less than a lower limit threshold frequency for a second time that signifies an underfrequency condition;
overvoltage detection circuitry (66, 68) operable to determine whether a voltage of the AC input power exceeds an upper limit threshold voltage for a third time that signifies an overvoltage condition; and
undervoltage detection circuitry (62, 64) operable to determine whether the voltage of the AC input power is less than a lower limit threshold voltage for a fourth time that signifies an undervoltage condition; and
a relay (34) connected to the power quality monitor circuitry for connection to the contactor (12), the relay being controlled to prevent closing of the contactor in response to a determination by the power quality monitor circuitry of the overfrequency condition, the underfrequency condition, the overvoltage condition or the undervoltage condition.

2. The power quality control circuit of claim 1, wherein the contactor (12) is configured to connect the AC input power to an aircraft AC bus when the contactor is closed.

3. The power quality control circuit of claim 1, wherein the relay (34) is a normally-open relay that is closed to enable closing of the contactor only in the absence of a determination by the power quality monitor circuitry of the overfrequency condition, the underfrequency condition, the overvoltage condition or the undervoltage condition.

4. The power quality control circuit of claim 1, wherein the contactor is configured to receive a control signal from a generator control unit (GCU) to control opening and closing of the contactor, and the relay is controlled to prevent closing of the contactor, regardless of whether the control signal from the GCU instructs the contactor to open, in response to the determination by the power quality monitor circuitry of the overfrequency condition, the underfrequency condition, the overvoltage condition or the undervoltage condition.

5. The power quality control circuit of claim 4, wherein the power quality monitor circuitry is configured to receive operating power from the GCU.

6. The power quality control circuit of claim 4, wherein the power quality monitor circuitry is configured to output an overfrequency status signal, an underfrequency status signal, an overvoltage status signal and an undervoltage status signal for communication to the GCU.

7. The power quality control circuit of claim 4, wherein the power quality monitor circuitry includes a built-in test circuit (72) controllable by the GCU to inject test signals to evaluate and ensure proper operation of the overfrequency detection circuitry, the underfrequency detection circuitry, the overvoltage detection circuitry and/or the undervoltage detection circuitry.

8. The power quality control circuit of claim 4, wherein the power quality monitor circuitry is physically located in a separate location from the GCU.

9. The power quality control circuit of claim 1, wherein the third time is between 225 and 275 milliseconds.

10. The power quality control circuit of claim 1, wherein the power quality monitor circuitry includes conditioning circuitry (50) that steps down the voltage of the AC input power for evaluation in the power quality monitor circuitry.

11. A method of monitoring power quality of an AC input power and selectively enabling connection of the AC input power through a contactor, the method comprising:
determining whether a frequency of the AC input power exceeds an upper limit threshold frequency for a first time that signifies an overfrequency condition;
determining whether the frequency of the AC input power is less than a lower limit threshold frequency for a second time that signifies an underfrequency condition;
determining whether a voltage of the AC input power exceeds an upper limit threshold voltage for a third time that signifies an overvoltage condition;
determining whether the voltage of the AC input power is less than a lower limit threshold voltage for a fourth time that signifies an undervoltage condition; and
selectively preventing closing of the contactor in response to determination of the overfrequency condition, the underfrequency condition, the overvoltage condition or the undervoltage condition.

12. The method of claim 11, wherein the contactor receives a control signal from a generator control unit (GCU) to control opening and closing of the contactor, and the contactor is selectively prevented from closing, regardless of whether the control signal from the GCU instructs the contactor to open, in response to the determination of the overfrequency condition, the underfrequency condition, the overvoltage condition or the undervoltage condition.

13. The method of claim 12, further comprising:
generating an overfrequency status signal, an underfrequency status signal, an overvoltage status signal and an undervoltage status signal based on a result of the determination of the overfrequency condition, the underfrequency condition, the overvoltage condition and the undervoltage condition; and
communicating the overfrequency status signal, the underfrequency status signal, the overvoltage status signal and the undervoltage status signal to the GCU.

14. The method of claim 11, wherein the third time is between 225 and 275 milliseconds.

15. The method of claim 11, further comprising:
stepping down the voltage of the AC input power prior to the steps of determining the overfrequency condition, the underfrequency condition, the overvoltage condition and the undervoltage condition.
